# EUROPEAN PATENT SPECIFICATION

(11) **EP 0 319 901 B1**
(45) Date of publication and mention of the grant of the patent: **05.10.1994**
(21) Application number: 88120318.6
(22) Date of filing: 06.12.1988
(51) Int. Cl.: H05K 7/14, H05K 5/02

(54) **Circuit board mounting apparatus**
Gerät zum Einstellen einer Schaltungsplatte
Appareil pour le montage d'une plaque de circuit

(30) Priority: 11.12.1987 JP 188525/87
(43) Date of publication of application: 14.06.1989
(73) Proprietor: UNIVERSAL CO. LTD., Oyama City Tochigi Prefecture (JP)
(72) Inventor: Okada, Kazuo, Minato-ku Tokyo (JP)
(74) Representative: LOUIS, PÖHLAU, LOHRENTZ & SEGETH

(56) References cited:
- EP-A- 0 195 145
- EP-A- 0 236 711
- DE-U- 8 232 702
- US-A- 4 138 711

## Description

### TECHNICAL FIELD

The present invention relates to a circuit board mounting apparatus by which a circuit board incorporating IC (integrated circuit) and the like is detachably mounted.

### RELATED BACKGROUND ART

In a conventional electronic equipment which is controlled by means of electronic circuits such as IC and the like, IC and various circuit devices are assembled and fixed on a predetermined circuit board to form a circuit block and when an electronic equipment is produced, a circuit block required for the use and functions of the electronic equipment is incorporated. A circuit board mounting apparatus in known from EP-A- 0 236 711 For example, in the case of a game machine controlled by electronic circuits, a circuit board having a control circuit for conducting more complicated control with heightening the content of the game is incorporated in the body of the game machine together with conventional mechanical components and device of electric source.

For incorporating a circuit board in such electronic equipment, however, it is necessary to electrically connect with the circuit board by inserting an edge of the circuit board into a connector mostly disposed at an invisible position or by moving the circuit board to the predetermined position and connecting with a connector at the end of a cord extending in the body. In particular, in a game machine such as a slot machine or the like, in consideration of operating position of a player, the circuit board as mentioned bove is usually set at a lower position in the body. When the circuit board is incorporated, an operator has to insert the circuit board and connect it taking care of the other electric parts and machinery with keeping his posture low, because the body has a hopper for accomodating coins and machinery such as rotary reel mechanism, etc. disposed closely. Accordingly, there have been problems such that, as well as poor workability, the operator often bumps his hands against the parts of machines placed around the circuit board or is injured by the edges of the circuit board itself, and that accidents are apt to occur such that IC is broken due to flow of excess current to the circuit board caused by wrong connection, etc.

### DISCLOSURE OF THE INVENTION

An object of the present invention is to overcome the above mentioned problems and to provide a circuit board mounting apparatus capable of attaching and detaching a circuit board with a high efficiency and a high safety in a limited space of an electronic equipment.

There is provided a circuit board mounting apparatus according to claims 1 and 2.

A case accomodating a circuit board is mounted on a circuit board holding member by engaging an extruding portion of the case with a supporting member for freely rotatively supporting the case, using the supporting member as support, whereby the terminal of the circuit board is connected with a connector. For disconnecting the connection, the circuit board case is moved rotatively in the reverse direction making the supporting member engaged with the extruding portion of the case as the supporting point, so that the terminal of the circuit board is detached from the connector and the case is taken off from the circuit board holding member.

According to the present invention, the extruding portion of the circuit board case is freely rotatively engaged with the supporting member, so that the circuit board can easily be attached to and detached from the connector of the holding member and is prevented from damage by carelessness during operation. Consequently, the circuit board can efficiently and safely be installed or taken off in a limited mounting space in an electronic equipment. Further, the position of the connector in the holding member can be set off the center to obtain an effect that the circuit board can be prevented from adverse insertion.

### BRIEF DESCRIPTION OF DRAWINGS

Fig. 1 is a perspective view showing an embodiment of the present invention;
Figs. 2 to 4 are side views showing functions of the embodiment of Fig. 1;
Figs. 5 and 6 are views showing the other embodiments, respectively; and
Fig. 7 is a view showing an inside construction of a slot machine using the embodiment of the present invention.

### DESCRIPTION OF SPECIAL EMBODIMENT

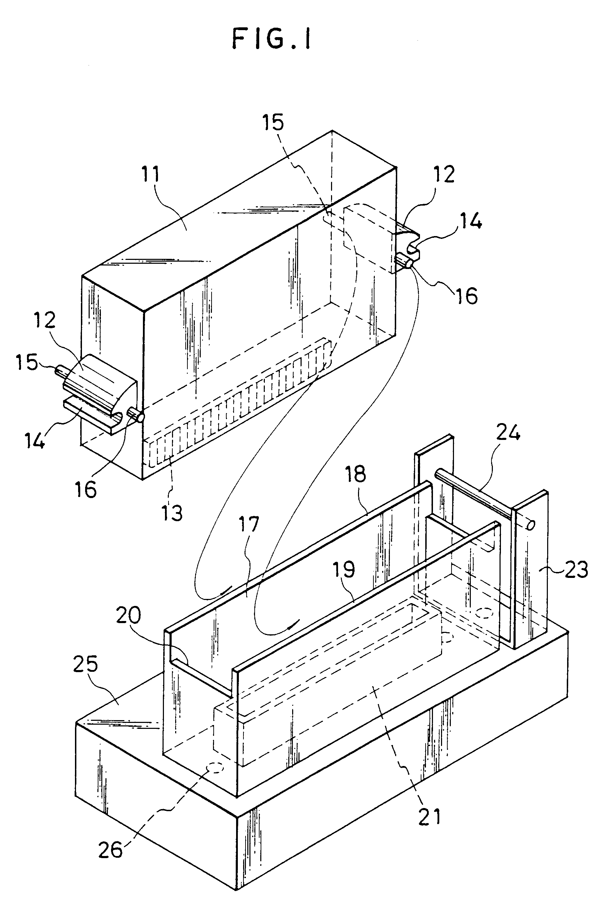

Fig. 1 shows an embodiment of the present invention. In the drawing, a case 11 is a rectangular parallelopiped accommodating a circuit board and has extruding portions 12 on its both end surfaces. An edge portion of the circuit board, that is, a terminal 13 is extruded from the lower surface of the case.

The extruding portion 12 is shorter in width than the case 11 and has a recess 14 at the top over the width for engaging with a supporting member 23 which will be explained later. Each of the extruding portions 12 is provided with pole-like projections 15, 16 extruding from its both sides in the vertical direction to the surfaces. The pair of projections 15 and 16 act as sliding portions for sliding along edges 18, 19 of a case accepting portion of a circuit board holding member 17. In this embodiment, since the extruding portion 12 having a shape shown in the drawing is provided on each of both end surfaces, the case can be inserted into the circuit board holding member 17 from each side and the extruding portion 12 in the front side can also be utilized as a grip when the case 11 mounted on the holding member 17 is taken off. However, the front extruding portion 12 is unnecessary to have the recess 14 and a pair of projections 15, 16 unless the case 11 is inserted in the reverse direction.

The circuit board case 11 mentioned above is mounted detachably and attachably on the holding member 17. The holding member 17 is formed as a rectangular parallelopiped box so as to accommodate the lower part of the case 11. The tops of both end surfaces thereof are cut off to form recess portions 20 in order to facilitate insertion of the case 11 with inclining it as mentioned later. Also, inside bottom surface of the holding member 17, there is disposed a connector 21 for electrically connecting with the terminal 13 of the circuit board when the case 11 is mounted.

Behind the rear surface of the holding member 17, there is disposed an angular U-shaped supporting member 23 at a predetermined distance. The supporting member 23 is provided with a crossbar 24 for fitting in the recess portion 14 of the extruding portion 12 of the case 11 so as to support the case freely rotatively. The crossbar 24 is settled at the position where the extruding portion 12 is engaged therewith when the pair of projections 15, 16 of the case 11 is slid from the front side to the rear side of the circuit board holding member 17.

The circuit board holding member 17 and the supporting member 23 are fixed with a fastener such as a screw 26 or the like at above-mentioned distance on a base 25 accommodating circuit devices such as an electric source and the like for electrically connecting with the circuit board via the connector 21.

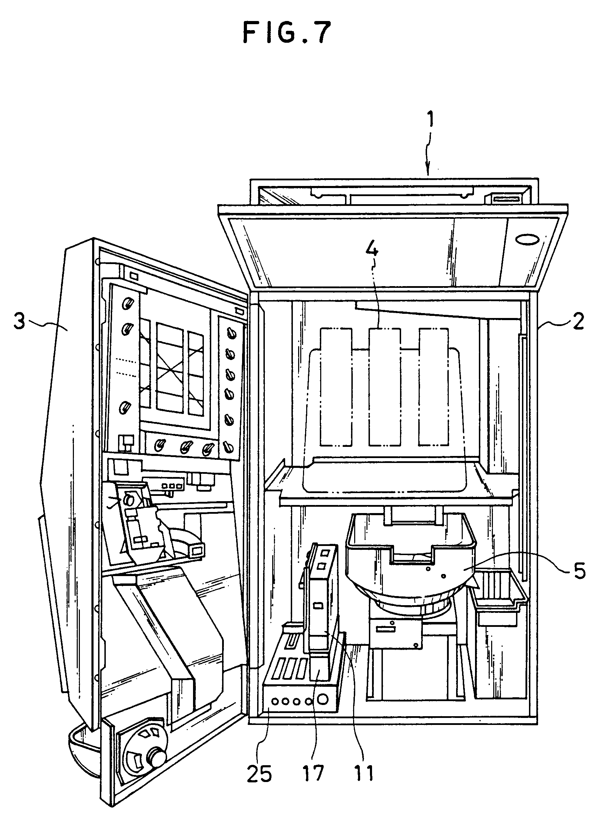

This embodiment is set at the lower part in the body 2 of, for example, a slot machine 1 as shown in Fig. 7. The body 2 of the slot machine shown in the drawing is equipped with a front door 3 so as to freely open and shut. The inside of the body 2 is partitioned into upper and lower parts. In the upper part, there are settled a rotary reel mechanism 4 of the slot machine and the like while in the lower part, there are set the base 25 on which the circuit board holding member 17 and the supporting member 23 mentioned above, together with a coin accommodating hopper 5 and the like. The circuit board case 11 is attachably and detachably held in the holding member 17.

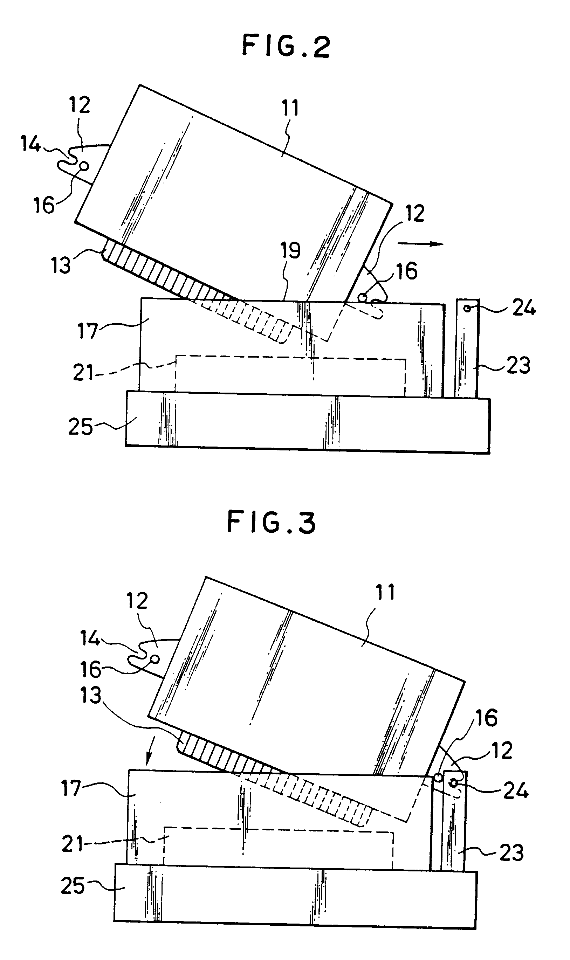

The function of the embodiment of Fig. 1 is described below with reference to Figs. 2 to 4.

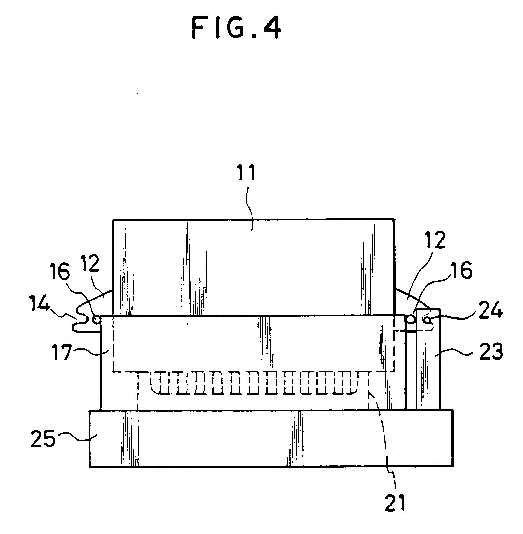

At first, when the circuit board case 11 is installed in the circuit board holding member 17, the case 11 is holded by hands, the pair of projections 15 and 16 of the extruding portion 12 positioned in the rear side are placed on the upper edges 18, 19 of the case acceptor portion of the holding member 17, and the lower portion of the rear side of the case 11 is put in holding member while the front side of the case 11 is lifted to incline the case 11 as shown in Fig. 2. Under this state, when the pair of projections 15 and 16 are slided along the upper edges 18, 19 of the holding member 17 to the rear ends, the pair of projections 15 and 16 are dropped into a space between the holding member 17 and the supporting member 23 and simultaneously the recess 14 of the extruding portion 12 is fitted in the crossbar 24 of the supporting member 23 as shown in Fig. 3. Subsequently, the front part of the case 11 is pushed down and moved rotatively making the crossbar 24 engaged with the extruding portion 12 as support to put the whole lower part of the case 11 into the holding member 17, whereby the terminal 13 of the circuit board is fitted in the connector 21 to electrically connect the circuit board with the devices in the base 25, as shown in Fig. 4.

When the case 11 is taken off for exchange or the like from the state where the circuit board has been installed as mentioned above, the extruding portion 12 of the front side is lifted by fingers, whereby the case 11 is moved rotatively upwards making the crossbar 24 as supporting point and the terminal 13 of the circuit board is separated from the connector 21, resulting in release of electrical connection with the devices in the base 25. Thereafter, when the case 11 is pulled frontwards in the lifting state, the pair of projections 15, 16 are slided along the upper edges 18, 19 of the circuit board holding member 17 so that the case 11 can easily be pulled out.

As mentioned above, the embodiment of Fig. 1 is constituted so that the circuit board is easily attached to and detached from the connector 21 in the holding member by rotatively engaging the extruding portion 12 of the circuit board case 11 with the crossbar 24 of the supporting member 23.

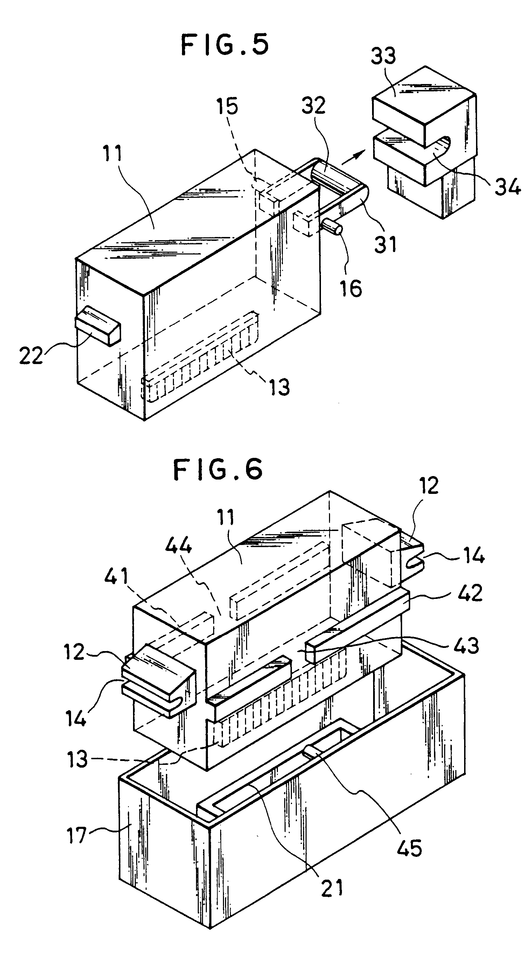

Next, Fig. 5 shows another embodiment.

In this embodiment, engaging structure of an extruding portion provided on an end surface of a circuit board case with a supporting member is reverse in relation to that in the embodiment of Fig. 1. That is, a case 11 has a U-shaped extruding portion 31 fixed on the rear end surface. This extruding portion 31 has a parallel part to the end surface of the case formed as a crossbar 32 having a circular cross section. On the other hand, a supporting member 33 is shaped like an angular pillar having a recess 34 on the top thereof for rotatably fitting therein the crossbar 32 of the extruding portion 31. Consequently, when the case 11 of this embodiment is attached to or detached from the circuit board holding member 17 mentioned above, the crossbar 32 of the extruding portion 31 is fitted in the recess 34 of the supporting member 33 and the case 11 is moved rotatively. Thus, the circuit board can easily be attached to or detached from the connector 21 in the holding member.

In this embodiment, the case 11 has a knob 22 extruding from the front surface and a pair of projections 15 and 16 mentioned above disposed in the right and left sides of the extruding portion 31 in the rear surface.

Fig. 6 shows another embodiment.

In this embodiment, in the same manner as in the embodiment of Fig. 1, a circuit board case 11 has extruding portions 12 on the front and rear surfaces. However, a sliding portion of the case 11 for sliding along upper edges 18, 19 of a circuit board holding member 17 comprises a pair of elongate projections 41 and 42, instead of the pair of projections 15 and 16 mentioned above, provided on the both side surfaces in longer directions of the case 11 parallel to the upper and lower surfaces. Each of the elongate projections 41 and 42 has a cutout 43 or 44 at the center. On the other hand, the holding member 17 has projections 45 provided near the upper ends of insides of both side walls, respectively.

Consequently, when the case 11 is attached to the circuit board holding member 17, the pair of elongate projections 41 and 42 is slided on the projections 45 of the holding member 17 from front side to the position of the rear surface and at the position where the cutouts 43, 44 meet the projections 45, the pair of the long projections 41, 42 are fallen down and simultaneously the recess 14 of the extruding portion 12 is engaged with the crossbar 24 of the supporting member 23. Accordingly, in the same manner as in the embodiment of Fig. 1, the front part of the case 11 is pushed down and moved rotatively making the crossbar 24 as supporting point, so that the terminal 13 of the circuit board can be fitted in the connector 21 to electrically connect with the devices in the base 25.

On the other hand, when the case 11 is taken off, the extruding portion 12 of the front side is lifted by fingers to move the case 11 rotatively upwards making the crossbar 24 as supporting point, whereby the terminal 13 of the circuit board is disconnected from the connector 21. Thereafter, when the case 11 is pulled frontwards in the lifted state, the pair of elongate projections 41, 42 are slid on the projections 45 so that the case 11 can easily be pulled out.

The circuit board case may be constituted so as to accommodate the edge portion of the circuit board inside without exposing it outside and to electrically connect with an external circuit by means of IC connector of the like. Further, the apparatus of the present invention can be applied for electronic equipments such as personal computer and the like having a circuit board holding member in which a cartridge-typed IC is attached and detached.

## Claims

1. A circuit board mounting apparatus comprising: a rectangular case (11) including a circuit board, said case having an extruding portion (12, 31) on at least a front end thereof, projections (15, 16) on opposite sides of the extruding portion and a circuit board terminal (13) projecting out of a bottom of said case;
a circuit board holding member (17) for accepting and holding said case (11), said holding member having an opening at the top thereof and a connector (21) disposed at the inside bottom surface of the holding member for electrically connecting with said terminal (13);
and a supporting member (23, 33) positioned adjacent one end of said holding member (17) for freely rotatively supporting said case by engaging with said extruding portion (12, 31) of said case (11); said projections (15, 16) of said case (11) being slidable along upper edges (18, 19) of said holding member (17), wherein said case (11) is mounted detachably and attachably on said circuit board holding member by rotatively moving said case (11), using said supporting member (23, 33) as a support.

2. A circuit board mounting apparatus comprising:
a rectangular case (11) including a circuit board, said case having an extruding portion (12, 31) on at least a front end thereof, a pair of elongate are projections (41, 42) extending in the longer direction of the case (11) and provided on both side surfaces of the case, each of the elongate projections (41, 42) having a cutout (43, 44) at its center, and a circuit board terminal (13) projecting out of the bottom of said case;
a holding member (17) for accepting and holding said case (11), said holding member having an opening at the top thereof and a connector (21) disposed at the inside bottom surface of the holding member for electrically connecting with said terminal (13), said holding member having projections (45) provided near the upper ends of insides of both its sidewalls; and a supporting member (23, 33) positioned adjacent one end of said holding member (17) for freely rotatively supporting said case, wherein the extruding portion (12, 31) engages with the supporting member (23, 33) when the cutouts (43, 44) meet the projections (45) of said holding member;
said projections (41, 42) of said case (11) being slidable along said projections (45) of said holding member (17), wherein said case (11) is mounted detachably and attachably on said circuit board holding member by rotatively moving said case (11), using making said supporting member (23, 33) as a support.

## Patentansprüche

1. Gerät zum Einstellen einer Schaltungsplatte, mit einem rechteckigen Gehäuse (11), das eine Schaltungsplatte enthält, wobei das Gehäuse an mindestens einem Vorderende einen vorstehenden Abschnitt (12, 31), an voneinander abgewandten Seiten des vorstehenden Abschnittes Vorsprünge (15, 16) und einen Schaltungsplattenanschluß (13) aufweist, der von einem Boden des Gehäuses heraus vorsteht, einem Schaltungsplatten-Halteelement (17) zur Aufnahme und Halterung des Gehäuses (11), wobei das Halteelement an seiner Oberseite eine Öffnung sowie einen Anschlußverbinder (21) aufweist, der zur elektrischen Verbindung mit dem Anschluß (13) an der Innenseite der Bodenfläche des Halteelementes angeordnet ist, und
einem Stützelement (23,33), das in der Nachbarschaft eines Endes des Halteelementes (17) zur frei drehbaren Halterung des Gehäuses durch Angriff an dem vorstehenden Abschnitt (12, 31) des Gehäuses (11) vorgesehen ist, wobei die Vorsprünge (15, 16) des Gehäuses (11) entlang oberer Ränder (18, 19) des Halteelementes (17) verschiebbar sind, und das Gehäuse (11) loslösbar und aufsteckbar am Schaltungsplatten-Halteelmeent (17) durch Drehen der Bewegung des Gehäuses (11) anbringbar ist, wobei das Stützelement (23, 33) als Stütze verwendet wird.

2. Gerät zum Einstellen einer Schaltungsplatte, mit einem rechteckigen Gehäuse (11), das eine Schaltungsplatte enthält, wobei das Gehäuse an mindestens einem Vorderende einen vorstehenden Abschnitt (12, 31) sowie ein Paar längliche Vorsprünge (41, 42) aufweist, die sich in Längsrichtung des Gehäuses (11) erstrecken und die an den beiden Seitenflächen des Gehäuses vorgesehen sind, wobei jeder der länglichen Vorsprünge (41, 42) in seinem Mittelbereich einen Ausschnitt (43, 44) besitzt, und ein Schaltungsplattenanschluß (13) vom Boden des Gehäuses heraus vorsteht,
einem Halteelement (17) zur Aufnahme und Halterung des Gehäuses (11), wobei das Halteelement an seiner Oberseite eine Öffnung sowie einen Anschlußverbinder (21) aufweist, der zur elektrischen Verbindung mit dem Anschluß (13) an der Innenseite der Bodenfläche des Halteelementes angeordnet ist, wobei das Halteelement Vorsprünge (45) aufweist, die in der Nachbarschaft der oberen Enden der Innenseiten seiner beiden Seitenwände vorgesehen sind, und ein Stützelement (23, 33) in der Nachbarschaft eines Endes des Halteelementes (17) zur freien drehbaren Halterung des Gehäuses vorgesehen ist, wobei der vorstehende Abschnitt (12, 31) am Stützelement (23, 33) angreift, wenn die Ausschnitte (43, 44) auf die Vorsprünge (45) des Halteelementes treffen, die Vorsprünge (41, 42) des Gehäuses (11) entlang den Vorsprüngen (45) des Halteelementes (17) verschiebbar sind, und das Gehäuse (11) durch drehende Bewegung des Gehäuses (11) loslösbar und aufsteckbar am Schaltungsplatten-Halteelement angeordnet ist, wobei das Stützelement (23, 33) als Stütze verwendet wird.

## Revendications

1. Dispositif de montage de carte imprimée comprenant :
un boîtier rectangulaire (11) comprenant une carte imprimée, ledit boîtier étant muni d'une partie proéminente (12, 31) à au moins une de ses extrémités, des saillies (15, 16) étant placées sur les deux faces opposées de la partie proéminente, et une borne de connexion (13) de la carte imprimée faisant saillie sur la partie basse dudit boîtier ;
un organe (17) de maintien de la carte imprimée destiné à recevoir et à maintenir ledit boîtier (11), cet organe étant ouvert en sa partie supérieure et doté d'un connecteur (21) disposé sur sa surface inférieure interne et permettant la connexion électrique avec ladite borne de connexion (13) ;
et un organe support (23, 33) positionné à proximité d'une extrémité de l'organe de maintien (17) pour supporter d'une manière libre en rotation ledit boîtier (11), lequel y est connecté par l'intermédiaire de la partie proéminente (12, 31); les saillies (15, 16) du boîtier (11) étant coulissables le long des arêtes supérieures (18, 19) de l'organe de maintien (17),
dans lequel le boîtier (11) est monté amovible sur l'organe de maintien de la carte imprimée grâce au mouvement rotatif du boîtier (11), utilisant l'organe support (23, 33) comme support.

2. Dispositif de montage de carte imprimée comprenant :
un boîtier rectangulaire (11) comprenant une carte imprimée, ledit boîtier étant doté d'une partie proéminente (12, 31) à au moins une de ses extrémités, une paire de barres externes allongées (41, 42) s'étendant dans la direction longitudinale du boîtier (11) et placées sur les deux surfaces latérales dudit boîtier, chacune d'entre elle ayant une interruption centrale (43, 44), et une borne de connexion (13) de la carte imprimée qui fait saillie sur la partie basse du boîtier ;
un organe de maintien (17) pour accueillir et maintenir le boîtier (11), ledit organe de maintien étant doté d'une ouverture à son extrémité supérieure et doté d'un connecteur (21) disposé sur la surface inférieure interne de l'organe de maintien et permettant la connexion électrique avec la borne de connexion (13), ledit organe de maintien ayant en outre des ergots (45) à proximité des extrémités supérieures à l'intérieur de ses deux parois latérales et un organe support (23, 33) placé au voisinage d'une extrémité de l'organe de maintien (17) et supportant le boîtier, lequel reste libre en rotation, la partie proéminente (12, 31) étant en prise avec ledit organe support (23, 33) lorsque les interruptions (43, 44) sont au niveau des ergots (45) dudit organe de maintien ;
lesdites saillies (41, 42) dudit boîtier (11) étant au surplus coulissables le long des ergots (45) de l'organe de maintien (17),
dans lequel le boîtier (11) est monté amovible sur l'organe de maintien de la carte imprimée en effectuant une rotation dudit boîtier (11), utilisant l'organe support (23, 33) comme support.
